# EUROPÄISCHE PATENTSCHRIFT

(11) **EP 2 150 504 B1**
(45) Veröffentlichungstag und Bekanntmachung des Hinweises auf die Patenterteilung: **27.02.2013**
(21) Anmeldenummer: 08758095.7
(22) Anmeldetag: 20.05.2008
(51) Int. Cl.: C04B 11/028, C04B 11/032

(54) **VERFAHREN ZUR HERSTELLUNG VON ALPHA-CALCIUMSULFAT-HALBHYDRAT AUS CALCIUMSULFAT-DIHYDRAT**
METHOD FOR THE PRODUCTION OF ALPHA-CALCIUM SULFATE HEMIHYDRATE FROM CALCIUM SULFATE DIHYDRATE
PROCÉDÉ DESTINÉ À PRODUIRE UN SEMI-HYDRATE DE SULFATE D'ALPHA CALCIUM À PARTIR DE DIHYDRATE DE SULFATE DE CALCIUM

(30) Priorität: 24.05.2007 DE 102007024188
(43) Veröffentlichungstag der Anmeldung: 10.02.2010
(73) Patentinhaber: Grenzebach BSH GmbH, 36251 Bad Hersfeld (DE)
(72) Erfinder: JÄGER, Reinhard, 36215 Bad Hersfeld (DE); BROSIG, Alfred, 38228 Salzgitter (DE)
(74) Vertreter: Kindermann, Peter
(86) Internationale Anmeldenummer: PCT/DE2008/000854
(87) Internationale Veröffentlichungsnummer: WO 2008/141627

(56) Entgegenhaltungen:
- EP-B- 0 572 781
- DE-C- 344 478
- DE-C- 937 276
- DE-C- 952 967
- GB-A- 1 224 149

## Beschreibung

Gips ist die mineralogisch-technischen Bezeichnung der chemischen Verbindung des Calciumsulfat-Dihydrates (CaSO₄ x 2H₂O).

Durch Zufuhr von thermischer Energie verliert Gips 1½ Moleküle seines chemisch gebundenen Kristallwassers je Formeleinheit, dadurch wird das Calciumsulfat-Dihydrat zu Calciumsulfat-Halbhydrat CaSO₄ x 0,5H₂O umgewandelt.

Vom Calciumsulfathalbhydrat existieren zwei technische Formen, die in der Praxis häufig als Alpha- und Beta-Modifikation unterschieden werden, obwohl sie chemischmineralogisch identisch sind. Erfolgt die Zufuhr der thermischen Energie bei atmosphärischem Druck, so erhält man die Beta-Modifikation des Calciumsulfat-Halbhydrates. Die Körner eines solchen Brennproduktes besitzen eine hohe Eigenporosität und bestehen aus unzähligen Einzelkristalliten. Ein Bindemittel aus diesem Halbhydrat besitzt auf Grund der hohen Oberfläche einen hohen Wasseranspruch bei der Verarbeitung, resultierend in einem Wasser-Gips-Wert von ca. 0,6 - 1,0. (Bestimmt über Einstreumenge; Prüfung nach EN 13279-1; September 2005). Das bedeutet, dass bei der Verarbeitung geringe Festigkeiten erhalten werden. Die Beta-Modifikation ist Hauptbestandteil des Stuckgipses, dem als Bindemittel für die Gipsmörtel- und Gipsplattenherstellung große Bedeutung zukommt.

Die vorliegende Erfindung betrifft die Herstellung der anderen Form des Calciumsulfat-Halbydrats, der Alpha-Modifikation.

Die Herstellung dieser Alpha-Modifikation des Calciumsulfat-Halbhydrates erfolgt aus übersättigten wässerigen Lösungen, und zwar in Lösungen von Elektrolyten aus Säuren und Salzen oder bei erhöhter Temperatur und erhöhtem Dampfdruck in Autoklaven. Diese Umwandlungen werden in der Regel unter Verwendung von Additiven durchgeführt, die die Morphologie der entstehenden Kristalle in einer erwünschten Form beeinflussen.

Im Gegensatz zur Beta-Modifikation werden hier gut ausgebildete Einzelkristalle erhalten, die nach Mahlung Bindemittel mit Wässergipswerten von ca. 0,3 bis 0,5 ergeben. Daraus resultieren deutlich höhere Festigkeiten in der Anwendung. Solche Bindemittel werden z.B. im Dentalbereich verwendet.

Kristallisiert Alpha-Calciumsulfat-Halbhydrat aus wässerigen Lösungen oder in Elektrolytlösungen, so verwendet man den Begriff "Nassverfahren". Bei den Nassverfahren mit wässrigen Lösungen wird die "neutrale" Fahrweise von der "sauren" Fahrweise unterschieden. Während bei der neutralen Fahrweise etwa pH- neutrale Gipse wie Natur- oder RES-Gipse ohne Einstellung des pH-Wertes umgewandelt werden (siehe z.B. GB 563 019), wird bei der sauren Fahrweise, meist kommen hier saure Ausgangsgipse wie Phosphogips zum Einsatz, der pH-Wert mit Schwefelsäure gezielt auf ca. 2 bis 3 eingestellt (DE 11 57 128 A1). Erfolgt dagegen die Herstellung von Alpha-Calciumsulfat-Halbhydrat in dampfbeaufschlagten Autoklaven so verwendet man den Begriff "Trockenverfahren" (siehe z.B. US 1 901 051).

Die Herstellung von Alpha-Calciumsulfat-Halbhydrat aus Elektrolytlösungen (US 2 616 789) hat sich in der industriellen Praxis nicht durchsetzen können, da an den Ausrüstungen erhebliche Korrosionen auftreten. Auch trafen die vor der Trocknung notwendigen verfahrenstechnischen Schritte der Entwässerung durch Filtration, der Filterkuchenwäsche und der Abwasserbehandlung auf unüberwindliche Schwierigkeiten. Zudem sind Anhaftungen und Verkrustungen durch abgebundenes Calciumsulfat-Dihydrat nicht zu vermeiden.

Beim "Trockenverfahren" wird grobstückiger Naturgips mit hoher Reinheit und kompaktem Kristallgefüge auf Hordenwagen oder in perforierten Stahlkörben gestapelt und in einem dampfbeaufschlagten Autoklaven erhitzt. Um einen hohen Umwandlungsgrad auch im Kernbereich zu erreichen, ist das Verweilen des Gipses in der gespannten Dampfatmosphäre für eine Zeitspanne von mehreren Stunden notwendig. Das gleiche Prinzip wird bei einem "Trockenverfahren" angewandt, bei dem zunächst feinteiliger Gips zu Steinrohlingen gepresst und anschließend der zuvor beschriebenen thermischen Behandlung in gespanntem Wasserdampf ausgesetzt wird (siehe z.B. DE 38 19 652 C3).

Ein weiterer Ansatz zu einem Trocken- bzw. Halbtrockenverfahren sieht nach DE 0937276 C und DE 4217978 A1, bzw. EP 0572781 B1 einen horizontalen (oder auch vertikalen) Rührwerksautoklav vor. Nach DE 093 7276 C baut das erste Kristallwasser, das aus dem Gips austritt, ggf. unterstützt durch vorhandene Bergfeuchte (bis ca. 3%), den Druck im Rührwerksautoklaven auf. Eingesetzt wird körniges Gut. Getrocknet werden kann in der Trommel.

Aus der DE 952 967 C ist eine Anlage zum Entwässern von Gipsen durch überhitzten gespannten Dampf bekannt, die einfacher im Aufbau und raumsparender ist als der damals bekannte Stand der Technik.

Die GB 1 224 149 A betrifft eine Produktionsanlage für alpha-Calciumsulfat-Halbhydrat bestehend aus einer Mischung von Gips und Wasser. Diese Mischung wird unter Wärmeeinwirkung und Druck mittels einer Transportschnecke in einem Autoklaven zu alpha-Calciumsulfat-Halbhydrat verarbeitet.

Aus der DE 344 478 C ist ein Verfahren zur Herstellung von Gips bekannt, bei dem Kalziumsulfat in einem geschlossenen Gefäß unter Druck und einer Temperatur von 180 bis 220°C ohne Zusatz von Feuchtigkeit oder Dampf behandelt wird.

Nach der DE 4217978 A1, bzw. EP 0572 781 B1 wird im horizontalen Rührwerksautoklav feinteiliges Gut ohne oder mit sehr geringer Wasserzugabe mit und ohne Additive umgewandelt. Eine Trocknung kann im Autoklav oder in einem nachgeschalteten Aggregat erfolgen.

Im Anspruch 1 der EP 0572 781 B1 wird ein Verfahren zur Herstellung von alpha-Calciumsulfat-Halbhydrat aus Calciumsulfat-Dihydrat nach dem Trockenverfahren beansprucht, bei dem feinkörniges Rohgut aufgegeben und unter der Einwirkung von Druck, Temperatur und Wasserdampf umgewandelt wird, das dadurch gekennzeichnet ist, dass das Gut in einem ruhenden Reaktor mit von außen angetriebenen Mischeinrichtungen oder in einem sich drehenden Reaktor mit feststehenden oder beweglichen Mischeinrichtungen im Inneren gemischt wird, und dass die Temperatur des Gutes im Reaktor fortlaufend gemessen und nach einem vorgewählten zeitlichen Verlauf geregelt wird.

In den Unteransprüchen wird weiterhin im Wesentlichen beansprucht, dass das Rohgut mit einem bestimmten Anteil an Oberflächenfeuchte mit einem reduzierten Anteil an Kristallwasser aufgegeben wird, dass Additive beigegeben werden, dass der Druck nach einem vorgewählten zeitlichen Verlauf geregelt wird, dass Wasserdampf entzogen und Luft beigemischt wird, und dass eine separate nachgeschaltete Trocknungsvorrichtung vorgesehen ist.

In der Beschreibung ist ferner von entsprechend gestalteten Mischwerkzeugen die Rede, die die Agglomerierung verhindern soll (Spalte 4,Z.15 - 19). Eine entsprechende detaillierte Offenbarung findet sich hierzu jedoch in der EP 0572 781 B1 nicht.

Anlagen gemäß dieser Offenbarung konnten bisher nicht erfolgreich betrieben werden. Eine Musteranlage wurde nach 2 - jährigem Versuchsbetrieb wegen unüberwindlicher technischer Schwierigkeiten abgerissen.

Der Widerruf des entsprechenden Patents erhielt am 23.07.1998 Rechtskraft.

Dem erfindungsgemäßen Verfahren liegt deshalb die Aufgabe zugrunde, ein Verfahren und eine Vorrichtung zur Herstellung von Alpha-Calciumsulfat-Halbhydrat aus Calcium-Dihydrat anzugeben, das auf energiesparende Weise kostengünstig und technisch zuverlässig seine Wirkung entfaltet.

Diese Aufgabe wird mittels eines Verfahrens nach dem Anspruch 1 und einer Vorrichtung nach Anspruch 11 gelöst.

Diese Verfahren bzw. die entsprechende Vorrichtung werden im Folgenden näher beschrieben.

Es zeigen im Einzelnen:
Figur 1: einen erfindungsgemäßen Rührwerksautoklaven
Figur 2: einen erfindungsgemäßen Rühwerksautoklaven mit Peripherie - Aggregaten

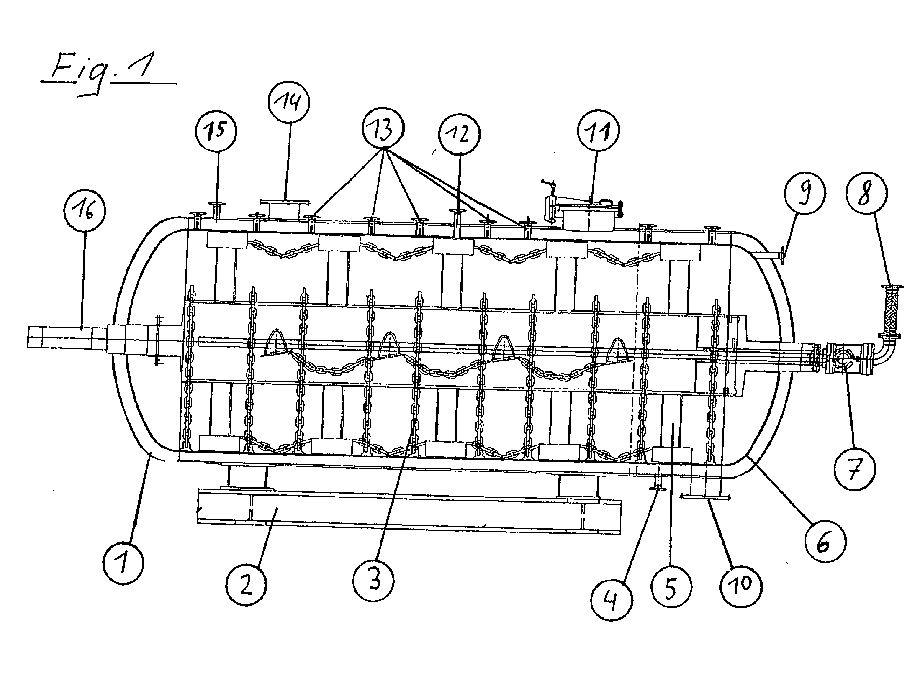

Der in der Fig.1 gezeigte Rührwerksautoklav (1) auf seinem Grundrahmen (2) zeichnet sich vor allem dadurch aus, dass er im Bereich des Rührwerks (5) in den Reaktionsraum hängende Ketten (3) aufweist.

Hier wurde ein in der Praxis üblicher indirekt beheizter horizontaler Paddeltrockner in der Art modifiziert, dass zwischen den, von der Antriebswelle (16) angetriebenen, rotierenden Rührorganen bewegliche Stahlketten (3) montiert wurden. Diese Stahlketten (3) besitzen im unteren Scheitelpunkt des Autoklaven (1) Bodenkontakt. Auch um die zentrale Rührwelle herum wurden gewichtsbelastete Stahlketten (3) durch Umschlingung zwischen den Paddelorganen frei beweglich angeordnet. Durch die Schwerkraft hängen die Stahlketten immer senkrecht nach unten und streifen jeglichen sich bildenden Materialansatz von der rotierenden zentralen Rührwerkswelle und von sonstigen für einen Materialansatz empfindlichen inneren Anlageteilen.

Zudem lassen sich durch die Beaufschlagung mit Ultraschall sowohl die Homogenisierungsprozesse fördern als auch die Anbackungen von Material reduzieren.

Einen ähnlichen Effekt haben besondere, die Haftung von Anbackungen verhindernde, für den Umwandlungsprozess neutrale, zusätzliche Beschichtungen der inneren Anlagenteile.

Die Wirkung der durch die Schwerkraft den unerwünschten Materialansatz abstreifenden Kettenglieder lässt sich erfindungsgemäß noch verstärken indem anstelle oder zusätzlich zu einzelnen Kettengliedern mit Kanten versehene mehr oder weniger schwere Körper wie Würfel oder ähnliche platonische Körper angebracht werden.

Zwischen dem Innenmantel (6) und dem Außenmantel des Rührwerksautoklaven wird Prozesswärme in der Form von Wasserdampf über die Dampfzufuhr (15) zugeführt. Das hierbei anfallende Kondensat wird über den Kondensat - Abfluss (4) abgelassen.

Das zentrale Rührwerk (5) wird ebenfalls über die Dampfzufuhr (8) beheizt, wobei das anfallende Kondensat über den Kondensat - Abfluss (7) abfließen kann.

Es ist jedoch auch erfindungsgemäß möglich die benötigte Prozesswärme über andere Energieträger zuzuführen. Zu denken ist hier an Sonnenenergie, Windenergie oder bei atomaren Prozessen anfallende Restwärme. Auf jede denkbare Art gewonnene elektrische Energie lässt sich vor allem über Mikrowellen den Prozess - Beteiligten zuführen.

Die für den Prozess benötigte Druckluft wird über die Druckluftzufuhr (9) zugeführt. Hierdurch erfolgt die Abfuhr von Restfeuchte. Da diese Druckluft kalt zugeführt wird, ist sie nach der Erwärmung in der Lage ein große Menge an Restfeuchte aufzunehmen.

Die Zufuhr des Rohgutes geschieht über die Rohgut - Eingabe (14).

Es ist allgemein bekannt, dass fein partikulärer Feststoff nach der Einmischung von Wasser oder anderen Flüssigkeiten zu Ansätzen an Kontaktflächen neigt. Daher ist es unmöglich, das zur Einstellung der optimalen Oberflächenfeuchte notwendige Wasser außerhalb des Autoklaven einzumischen, da die Materialbeschickung des Autoklaven durch Verstopfung kollabieren würde. Demzufolge ist es notwendig, dass das Wasser auf das bereits im Autoklaven befindliohe und bewegte Calciumsulfat-Dihydrat aufgedüst wird.

Es wird deshalb das für den Prozess notwendige Wasser über die Sprühdüsen (13) zugeführt.

Nach der Umwandlung von Calciumsulfat-Dihydrat und der Kristallisation zu Alpha-Calciumsulfat-Halbhydrat verbleibt das Material im Autoklaven. Weiterhin wird thermische Energie in den Doppelmantel des Autoklaven zugeführt, jedoch der Druck im Reaktionsraum kontinuierlich reduziert. Damit vergrößert sich die Sättigungstemperaturdifferenz zwischen beheiztem Doppelmantel und Reaktionsraum, was zu einem höheren Energiefluss und somit zu einer beschleunigten Trocknung führt. Der Trocknungsvorgang wird abgeschlossen, in dem kurzzeitig Druckluft in den Reaktionsraum geblasen wird. Die erwärmte Druckluft hat ein großes Potential zur Aufnahme der Restfeuchte aus dem Alpha-Calciumsulfat-Halbhydrat.

Das absolut trockene Alpha-Calciumsulfat-Halbhydrat wird aus dem Reaktionsraum entleert und kann nun dem Auslass (10) entnommen werden.

Der Prozessdampf - Auslass erfolgt über die Öffnung (12) und eine eventuelle Inspektion der Anlage ist über die Inspektionsöffnung (11) möglich.

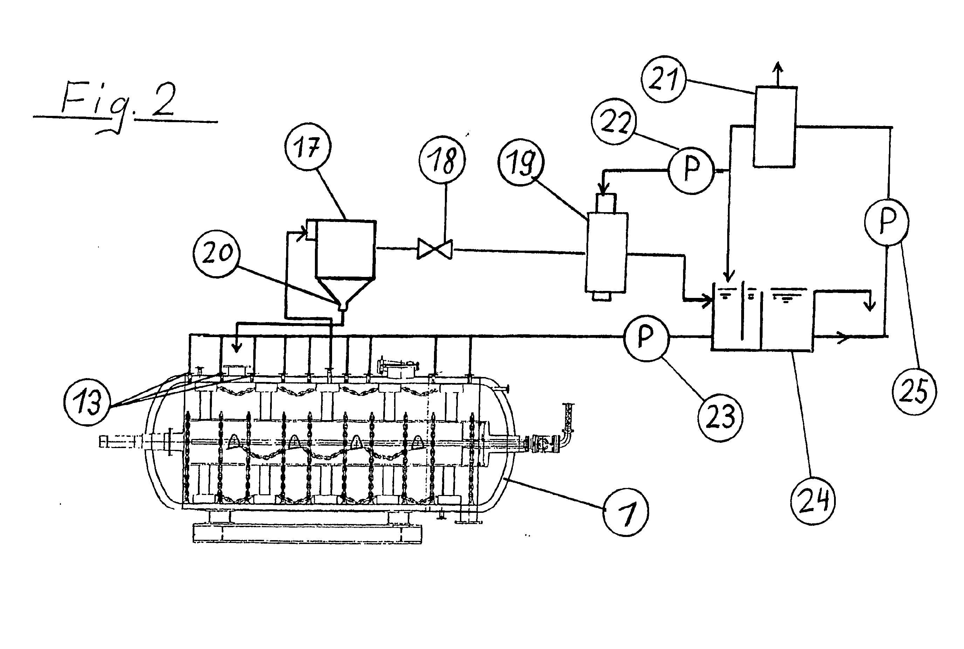

Aus der Fig. 2 sind die für den optimalen Betrieb des erfindungsgemäßen Rührwerkautoklaven notwendigen Zusatzaggregate zu entnehmen.

So führt der Prozessdampf - Auslass (12) auf einen, in der Fig.2 mit dem Bezugszeichen (17) gekennzeichneten, als so genanntes Dampfschloss wirkenden, Dampfzyklon.

Zur Fliehkraftabscheidung von Stäuben verwendet man in der Chemietechnik Zyklone. Hierbei handelt es sich um einen zylinderförmigen Apparat, der sich im unteren Bereich verjüngt. Das zu entstaubende Rohgas strömt dabei von oben tangential in den Zyklon ein und wird durch die Zyklonwand auf eine Kreisbahn gezwungen. Dadurch entsteht ein rotierender Gaswirbel. Die mitrotierenden Staubteilchen werden von der Fliehkraft an die Wand geschleudert, flocken zu Agglomeraten zusammen und fallen an der Wand nach unten. Dort werden sie mit einem Zellenrad aus dem Zyklon genommen.

Der Gaswirbel bewegt sich rotierend an der Apparatewand nach unten in den sich verengenden Teil und vermindert dabei seinen Kreisdurchmesser. Da er nach unten nicht aus dem Apparat austreten kann, wird er am Apparateboden umgelenkt und steigt rotierend mit vermindertem Durchmesser nach oben, wo er den Zyklon durch das Tauchrohr verlässt.

Im Fall der Fig.2 dient der Dampf - Zyklon (17) dazu den Prozess - Dampf von den anfallenden Stäuben zu reinigen. Dies gelingt in dieser Stufe mit einem Wirkungsgrad bis zu 95%. Bei dem im Dampf - Zyklon anfallenden Staub handelt es sich zumeist um Alpha- Calciumsulfat-Halbhydrat - Keime die dem Autoklav (1) über die bezeichnete Rückführung (20) wieder zugesetzt werden können Die restlichen Stäube werden dann über den Venturi - Wäscher (19) ausgeleitet und können ebenfalls dem Gesamtprozess zugesetzt werden.

Die Prozesswasser - Pumpe (23) liefert das der Wasser - Zuführung (22) entnommene Wasser über die Sprühdüsen (13) in den Rührautoklaven (1).Das im Kondensierer (21) und im Prozesswasser - Kühler (24) anfallende Wasser wird wieder dem Prozess zugesetzt. Das Ablassen von Prozessdampf erfolgt über das Regelventil (18).

Die entsprechenden Leitungsverläufe sind im Wesentlichen von der Funktion bestimmt.

Der Zusatz von Additiven, die das Kristallwachstum beeinflussen wurde nicht extra dargestellt. Es können alle aus dem Stand der Technik für dieses Verfahren bekannten Additive verwendet werden.

Durch das erfindungsgemäße Verfahren bzw. die erfindungsgemäße Vorrichtung ist gewährleistet, dass die Herstellung von Alpha-Cylcium-Halbydrat aus Calcium-Dihydrat energiesparend und betriebssicher erfolgt und ein Alpha-Calcium-Halbhydrat von hoher Qualität liefert.

Durch den gleichzeitigen Betrieb und eine verfahrenstechnische Vernetzung von mehreren erfindungsgemäßen Vorrichtungen lässt sich der Gesamtwirkungsgrad einer solchen Anlage weiter erhöhen.

### Bezugszeichenliste

- (1): Rührwerksautoklav
- (2): Sockel
- (3): Ketten
- (4): Kondensat - Abfluss (Mantelheizung)
- (5): Rührwerk (beheizt)
- (6): Innenmantel
- (7): Kondensat - Ausfluss (Rührwerkheizung)
- (8): Dampfzufuhr (Rührwerkheizung)
- (9): Druckluftzufuhr
- (10): Auslass des Alpa-Calciumsulfat-Halbhydrates
- (11): Inspektionsöffnung
- (12): Prozessdampf - Auslass
- (13): Sprühdüsen
- (14): Rohgut - Eingabe
- (15): Dampfzufuhr (Mantelheizung)
- (16): Antriebswelle (Rührwerk)
- (17): Dampf - Zyklon
- (18): Regelventil, Stellventil
- (19): Venturi - Wäscher
- (20): Alpha - Keim - Rückführung
- (21): Kondensierer
- (22): Wasser - Zuführung
- (23): Prozesswasser - Pumpe
- (24): Prozesswasser - Kühler

## Patentansprüche

1. Verfahren zur Herstellung von Alpha-Calciumsulfat-Halbhydrat aus Calciumsulfat-Dihydrat mit den folgenden Merkmalen:
a) Beschickung eines Rührautoklaven (1) mit Calciumsulfat-Dihydrat,
b) indirekte Beheizung des Rührautoklaven (1),
c) gesteuerte Zugabe und Einmischung von Wasser, wobei die gesteuerte Zugabe von Wasser in der Form der Einleitung durch gleichmäßige oder ungleichmäßig am Umfang des Rührautoklaven (1) verteilte Sprühdüsen (13) erfolgt,
d) Verhinderung von Anbackungen an Flächen des Reaktionsraums durch bewegte, an den Paddeln und / oder der Antriebswelle (16) des Rührautoklaven (1) angebrachte, Ketten (3),
e) intervallmäßige oder kontinuierliche Regelung des Drucks im Reaktionsraum durch Dampfabfluss bei dem Erreichen eines bestimmten Drucks im Innenraum, wobei der Dampf über einen Zyklonabscheider (17) und ein Stellventil (18) geführt wird und dem Zyklonabscheider (17) ein Venturiwäscher (19) nachgeschaltet ist,
f) Zufuhr von kalter Luft zur Resttrocknung,
g) Entfernen des Prozessgutes.

2. Verfahren nach Anspruch 1,
**gekennzeichnet durch**
a) eine Zugabe von Keimen in der Form von Alpha-Calciumsulfat- Halbhydrat und
b) die gesteuerte Zugabe und Einmischung von im Wasser gelösten Additiven.

3. Verfahren nach einem der vorhergehenden Ansprüche, **dadurch gekennzeichnet,**
**dass** das im Zyklonabscheider (17) und / oder dem Venturi - Wäscher abgeschiedene Material wieder zur Herstellung von Alpha- Calciumsulfat-Halbhydrat verwendet wird.

4. Verfahren nach einem der vorhergehenden Ansprüche,
**dadurch gekennzeichnet,**
**dass** zur Beschickung des Rührautoklaven (1) gemahlener Naturgips, Rauchgasentschwefelungsgips oder sonstiger feinteiliger synthetischer Gips verwendet wird.

5. Verfahren nach einem der vorhergehenden Ansprüche,
**dadurch gekennzeichnet,**
**dass** zur Beheizung des Rührautoklaven (1) fossile Energieträger, Sonnenenergie, Windenergie oder atomare Restwärme verwendet wird.

6. Verfahren nach einem der vorgehenden Ansprüche,
**dadurch gekennzeichnet,**
**dass** die Zugabe von Keimen in einem Umfang bis zu 5% der Masse des Calciumsulfat-Dihydrates erfolgt.

7. Verfahren nach einem der vorhergehenden Ansprüche,
**dadurch gekennzeichnet,**
**dass** die Zugabe von Wasser in einem Umfang von bis zu 20% der Masse des Calciumsulfat-Dihydrates erfolgt.

8. Verfahren nach einem der vorhergehenden Ansprüche,
**dadurch gekennzeichnet,**
**dass** mehrere Rührautoklaven (1) verfahrenstechnisch im Verbund betrieben werden.

9. Vorrichtung zur Herstellung von Alpha-Calciumsulfat-Halbhydrat aus Calciumsulfat-Dihydrat in einem Rührautoklaven (1) mit den folgenden Merkmalen:
a) der Rührautoklav (1) ist doppelwandig und indirekt beheizt, wobei die Mittel (5) zum Verrühren des Beschickungsgutes beheizbar ausgebildet sind,
b) am Mantel des Rührautoklaven (1) verteilte Sprühdüsen (13) sind so ausgebildet, dass durch sie Betriebsmittel einleitbar sind,
c) im Bereich des Rührwerks (5) sind lose hängende Ketten (3) befestigt,
d) dem Rührautoklaven (1) sind ein Zyklonabscheider (17) sowie ein Venturiwäscher (18) nachgeschaltet.

10. Vorrichtung nach Anspruch 9,
**dadurch gekennzeichnet,**
**dass** das im Zyklonabscheider (17) und dem Venturiwäscher (18) abgeschiedenes Material wieder dem Rührautoklaven (1) zugeführt wird.

11. Vorrichtung nach einem der Ansprüche 9 oder 10,
**dadurch gekennzeichnet,**
**dass** mehrere Autoklaven (1) im Verbund betrieben werden.

## Claims

1. Process for the production of alpha-calcium sulphate hemihydrate from calcium sulphate dihydrate, said process comprising the following features:
a) an agitated autoclave (1) is charged with calcium sulphate dihydrate,
b) the agitated autoclave (1) is heated indirectly,
c) water is added and mixed in in a controlled manner, water being added in a controlled manner by introducing it through spray nozzles (13) distributed uniformly or nonuniformly on the circumference of the agitated autoclave (1),
d) material is prevented from adhering to surfaces of the reaction chamber by moving chains (3) fitted to the paddles and/or the drive shaft (16) of the agitated autoclave (1),
e) the pressure in the reaction chamber is regulated at intervals or continuously by discharging steam when a specific pressure has been reached in the interior, the steam being guided via a cyclone separator (17) and an actuating valve (18), and a Venturi scrubber (19) being connected downstream of the cyclone separator (17),
f) cold air is fed in for residual drying, and
g) the process material is removed.

2. Process according to Claim 1,
**characterized by**
a) an addition of nuclei in the form of alpha-calcium sulphate hemihydrate, and
b) the controlled addition and mixing-in of additives dissolved in water.

3. Process according to one of the preceding claims,
**characterized**
**in that** the material deposited in the cyclone separator (17) and/or the Venturi scrubber is reused for the production of alpha-calcium sulphate hemihydrate.

4. Process according to one of the preceding Claims,
**characterized**
**in that** the agitated autoclave (1) is charged using ground natural gypsum, flue gas desulphurization gypsum or other finely-divided, synthetic gypsum.

5. Process according to one of the preceding Claims,
**characterized**
**in that** the agitated autoclave (1) is heated using fossil energy carriers, solar energy, wind energy or residual atomic heat.

6. Process according to one of the preceding claims,
**characterized**
**in that** nuclei are added to an extent of up to 5% of the mass of the calcium sulphate dihydrate.

7. Process according to one of the preceding claims,
**characterized**
**in that** water is added to an extent of up to 20% of the mass of the calcium sulphate dihydrate.

8. Process according to one of the preceding claims,
**characterized**
**in that** a plurality of agitated autoclaves (1) are operated jointly by process technology.

9. Device for the production of alpha-calcium sulphate hemihydrate from calcium sulphate dihydrate in an agitated autoclave (1), said device comprising the following features:
a) the agitated autoclave (1) has two walls and is heated indirectly, the means (5) for agitating the charged material being heatable,
b) spray nozzles (13) distributed on the jacket of the agitated autoclave (1) are designed such that operating means can be introduced through them,
c) loosely hanging chains (3) are fastened in the region of the agitator (5), and
d) a cyclone separator (17) and a Venturi scrubber (19) are connected downstream of the agitated autoclave (1).

10. Device according to Claim 9,
**characterized**
**in that** the material deposited in the cyclone separator (17) and the Venturi scrubber (19) is fed back to the agitated autoclave (1).

11. The device according to either of Claims 9 and 10,
**characterized**
**in that** a plurality of autoclaves (1) are operated jointly.

## Revendications

1. Procédé destiné à produire un semi-hydrate de sulfate de calcium alpha à partir de dihydrate de sulfate de calcium, présentant les caractéristiques suivantes:
a) chargement d'un autoclave à agitation (1) avec du dihydrate de sulfate de calcium,
b) chauffage indirect de l'autoclave à agitation (1),
c) ajout contrôlé et mélange d'eau, l'ajout contrôlé d'eau étant effectué sous la forme de l'introduction par des ajutages de pulvérisation (13) répartis uniformément ou non uniformément à la périphérie de l'autoclave à agitation (1),
d) prévention d'accumulations sur des surfaces de la chambre de réaction au moyen de chaînes mobiles (3) attachées aux pales et/ou à l'arbre d'entraînement (16) de l'autoclave à agitation (1),
e) régulation intermittente ou continue de la pression dans la chambre de réaction par évacuation de vapeur lors de l'atteinte d'une pression déterminée dans la chambre intérieure, la vapeur étant conduite au moyen d'un séparateur à cyclone (17) et d'une soupape de réglage (18) et un laveur à Venturi (19) étant installé en aval du séparateur à cyclone (17),
f) apport d'air froid pour le séchage résiduel,
g) enlèvement du produit du traitement.

2. Procédé selon la revendication 1, **caractérisé par**:
a) un ajout de germes sous la forme de semi-hydrate de sulfate de calcium alpha, et
b) l'ajout contrôlé et le mélange d'additifs dissous dans l'eau.

3. Procédé selon l'une quelconque des revendications précédentes, **caractérisé en ce que** la matière séparée dans le séparateur à cyclone (17) et/ou le laveur à Venturi est de nouveau utilisée pour la production de semi-hydrate de sulfate de calcium alpha.

4. Procédé selon l'une quelconque des revendications précédentes, **caractérisé en ce que** l'on utilise, pour le chargement de l'autoclave à agitation (1), du gypse naturel moulu, du gypse de désulfuration de gaz de fumées ou un autre gypse synthétique finement divisé.

5. Procédé selon l'une quelconque des revendications précédentes, **caractérisé en ce que** l'on utilise, pour le chauffage de l'autoclave à agitation (1), des porteurs d'énergie fossiles, l'énergie solaire, l'énergie éolienne ou la chaleur atomique résiduelle.

6. Procédé selon l'une quelconque des revendications précédentes, **caractérisé en ce que** l'ajout de germes est effectué en une quantité pouvant atteindre 5 % de la masse du dihydrate de sulfate de calcium.

7. Procédé selon l'une quelconque des revendications précédentes, **caractérisé en ce que** l'ajout d'eau est effectué en une quantité pouvant atteindre 20 % de la masse du dihydrate de sulfate de calcium.

8. Procédé selon l'une quelconque des revendications précédentes, **caractérisé en ce que** l'on utilise plusieurs autoclaves à agitation (1) en une combinaison technologique.

9. Dispositif destiné à produire un semi-hydrate de sulfate de calcium alpha à partir de dihydrate de sulfate de calcium dans un autoclave à agitation (1), présentant les caractéristiques suivantes:
a) l'autoclave à agitation (1) est à double paroi et est chauffé indirectement, les moyens (5) destinés à l'agitation de la matière de charge pouvant être chauffés,
b) des ajutages de pulvérisation (13) répartis sur la surface latérale de l'autoclave à agitation (1) sont réalisés de telle manière que des moyens de production puissent être introduits à travers ceux-ci,
c) des chaînes (3) pendant librement sont fixées dans la région de l'agitateur (5),
d) un séparateur à cyclone (17) ainsi qu'un laveur à Venturi (19) sont disposés en aval de l'autoclave à agitation (1).

10. Dispositif selon la revendication 9, **caractérisé en ce que** la matière séparée dans le séparateur à cyclone (17) et le laveur à Venturi (19) est de nouveau fournie à l'autoclave à agitation (1).

11. Dispositif selon l'une quelconque des revendications 9 ou 10, **caractérisé en ce que** plusieurs autoclaves (1) sont exploités en combinaison.
